# EUROPÄISCHE PATENTSCHRIFT

(11) **EP 0 423 486 B1**
(45) Veröffentlichungstag und Bekanntmachung des Hinweises auf die Patenterteilung: **30.03.1994**
(21) Anmeldenummer: 90117611.5
(22) Anmeldetag: 13.09.1990
(51) Int. Cl.: C23C 14/32, C23C 14/54

(54) **Vorrichtung und Verfahren zum Beschichten von Werkstücken mittels Bogenentladung**
Apparatus and process for coating workpieces by arc discharge
Dispositif et procédé pour revêtir des pièces utilisant une décharge d'arc

(30) Priorität: 15.09.1989 DE 3930832
(43) Veröffentlichungstag der Anmeldung: 24.04.1991
(73) Patentinhaber: Nishibori, Mineo, Dr., D-75239 Eisingen (DE)
(72) Erfinder: Nishibori, Mineo, Dr., D-75239 Eisingen (DE)
(74) Vertreter: Twelmeier, Ulrich, Dipl. Phys.

(56) Entgegenhaltungen:
- DE-A- 1 941 254
- DE-A- 2 820 286
- GB-A- 2 167 774
- US-A- 4 461 799
- SURFACE AND COATINGS TECHNOLOGY, 52 (1992), Seiten 229-233

## Beschreibung

Die Erfindung betrifft eine Vorrichtung zum Beschichten von Werkstücken mittels Bogenentladung, wodurch Kathodenmaterial zur Beschichtung des Werkstücks verdampft wird, mit einer Vakuumkammer und mindestens einem in dieser angeordneten Elektrodenpaar sowie ein Verfahren zum Beschichten von Werkstücken mittels Bogenentladung, wobei zunächst ein Unterdruck geschaffen wird und danach bei aufrechterhaltenem Unterdruck aus mindestens einer Kathode mittels Gasentladung Kathodenmaterial, Zonen und -tröpfchen erzeugt werden, die sich auf dem Werkstück absetzen.

Es sind verschiedene Verfahren zur Beschichtung von Werkstücken, wie Gußteilen, Werkzeugen, Uhrgehäusen, Schmuckstücken oder dergleichen bekannt. Bei Beschichtung mittels Bogenentladung wird zunächst ein Vakuum erzeugt. Anschließend werden mittels Bogenentladung zwischen Anode und Kathode aus letzterer Zonen und Tröpfchen aus Kathodenmaterial freigesetzt, die durch eine angelegte Hochspannung von beispielsweise 1000 Volt Gleichstrom auf das Werkstück beschleunigt werden. Die Teilchen geben ihre thermische Energie an das Werkstück ab und heizen damit dessen Oberfläche auf. Weiterhin werden Teilchen auf dem Werkstück zur Beschichtung abgelagert. Bei einer Stickstoffatmosphäre in der Beschichtungskammer können beispielsweise Nitridschichten, wie bei einer Ti-Kathode TiN-Schichten auf Schneid- oder Formwerkzeugen erzeugt werden (vgl. z.B. US-A-4 461 799).

Dieses Verfahren ist in der Praxis noch mit Problemen verbunden. Während die erste Beschichtungsschicht wichtig ist, haften die Zonen und Tröpfchen nur sehr schwach auf der Oberfläche und können wandern. Insbesondere kühlen größere Teilchen, wie Tröpfchen, auf der kalten Oberfläche sehr schnell ab und werden als solche auf dieser angelagert. Man hat festgestellt, daß während des weiteren Aufheizens der Oberfläche und der Beschichtung Zonen, die sich neben diesem Teilchen ablagern, dieses dann zunächst abgelagerte größere Teilchen teilweise unterwandern und von der Oberfläche ab nach außen drücken können, so daß unter dem Teilchen ein Leerraum entsteht, der die Beschichtung beeinträchtigt. Weiterhin ergeben sich grundsätzlich bei diesen Verfahren zunächst grobe Schichten geringer Dichte mit keilförmigen Ablagerungen und rauher unebener Oberfläche. Bei engerer Beschichtung und weiterem Aufheizen mag sich zwar eine dichte Schicht auf dieser ersten absetzen, diese reproduziert aber die Unebenheiten der ersten Ablagerungen, abgesehen davon, daß durch übereinanderliegende Schichten unterschiedlicher Struktur die hinreichende Härte der Beschichtung nicht erreicht wird, diese vielmehr durch die untere Schicht geringerer Dicke leicht ab- und aufbrechen kann.

Der Erfindung liegt daher die Aufgabe zugrunde, eine Vorrichtung und ein Verfahren zu schaffen, damit eine dichte, harte Beschichtungsschicht mit gleichmäßiger Oberfläche und guter Haftung erreicht werden kann.

Erfindungsgemäß wird die genannte Aufgabe durch eine Vorrichtung der eingangs genannten Art gelöst, welche durch das Kennzeichen des Anspruchs 1 ausgebildet ist. Vor Einsetzen der Bogenentladung zur Beschichtung des Werkstücks wird dieses mittels der zusätzlichen Heizeinrichtung auf die gewünschte Temperatur voraufgeheizt, um unter Vermeidung der oben genannten Nachteile und Beschichtungsfehler sogleich eine dichte, auf der Oberfläche glatte Beschichtungsschicht zu erzielen. Demgemäß ist ein erfindungsgemäßes Beschichtungsverfahren der gattungsgemäßen Art durch das Kennzeichen des Anspruchs 9 ausgebildet. Das Aufheizen geschieht mittels der zusätzlichen, in der Vakuumkammer der Beschichtungsvorrichtung vorgesehenen Heizeinrichtung. Es hat sich herausgestellt, daß in diesem Bereich Beschichtungsschichten mit hoher Dichte erzielt werden, bei denen eine säulenförmige Schicht mit dicht gepackten und dünnen Säulen erzeugt wird, die eine Oberfläche mit geringen Rauhigkeiten aufweist.

In bevorzugter Weise ist vorgesehen, daß die Heizeinrichtung ein Heizstrahler ist, da hierdurch am effektivsten die erzeugte Wärme auf das Werkstück übertragen wird. Die Heizeinrichtung kann dabei ein Rohrheizkörper sein. Da das Ziel ist, das Werkstück aufzuheizen, während zum Äußeren der Vakuumkammer hin die Temperatur möglichst abgebaut werden soll, sieht eine weitere Ausbildung der Erfindung vor, daß zwischen Heizeinrichtung und Wandung der Vakuumkammer Mittel zum Temperaturabbau von der Heizeinrichtung zur Wandung angeordnet sind, wobei insbesondere die Mittel zum Temperaturabbau Reflektorplatten sind und die Reflektorplatten aus poliertem Edelstahl bestehen. Hierdurch kann die Wärmestrahlung in den Innenraum der Vakuumkammer zurückreflektiert werden. Weitere Ausbildungen sehen vor, daß mehrere Reflektorplatten hintereinander mittels Abstandshaltern auf Abstand gehalten sind, und insbesondere, daß in der Vakuumkammer ein mit der Versorgung der Heizeinrichtung verbundener Thermostat vorgesehen ist. Hierdurch wird erreicht, daß auch bei der später einsetzenden Beschichtung die Temperatur des zusätzlichen Heizers geregelt werden kann und daher die Temperatur des Substrats nicht zu hohe Werte annimmt, wodurch sich ebenfalls eine auf ihrer Oberfläche unregelmäßige, durch einzelne Kristallite gebildete Schicht ergeben würde. In bevorzugter Weiterbildung ist vorgesehen, daß bei Titan als Kathodenmaterial das anfängliche Aufheizen bis auf 400-550 °C erfolgt.

Die erfindungsgemäße Vorrichtung ist weiterhin in an sich bekannter Weise dadurch ausgebildet, daß an das Innere der Vakuumkammer eine Gasverbindung mit einem Ventil angeschlossen ist, die zu einer Vakuumpumpe führt, durch welche das Vakuum erzeugt wird. Die Außenwandung der Kammer kann doppelwandig ausgebildet sein, wobei in dem Zwischenraum Kühlflüssigkeit zirkuliert, die über einen externen Wärmetauscher abgekühlt wird.

In Weiterbildung des Verfahrens ist vorgesehen, daß die Temperatur der Werkstücke über die Beschichtungszeit auf einen festen Wert eingeregelt wird.

Weitere Vorteile und Merkmale der Erfindung ergeben sich aus den Ansprüchen und aus der nachfolgenden Beschreibung, in der ein Ausführungsbeispiel der Erfindung unter Bezugnahme auf die Zeichnung im einzelnen erläutert ist. Dabei zeigt:

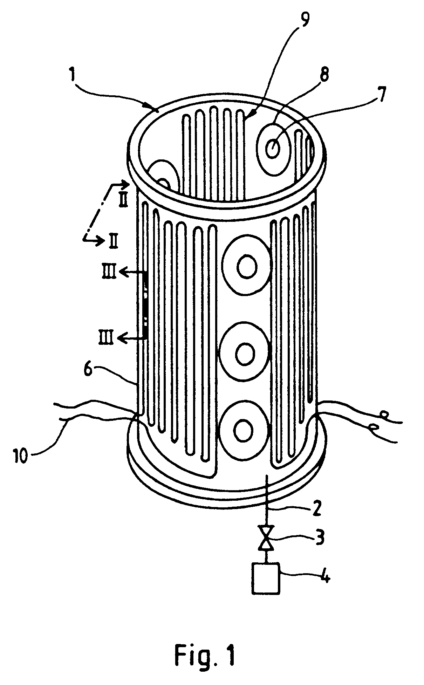

- Figur 1: eine schematische erste Ausführungsform der wesentlichen Merkmale der erfindungsgemäßen Vorrichtung;
- Figur 2: einen Horizontalschnitt entsprechend II-II der Figur 1;
- Figur 3: einen Vertikalschnitt entsprechend III-III der Figur 1;
- Figur 4: die Beschichtungsstruktur als Funktion der Substrattemperatur; und
- Figur 5 a-c: Schnitte senkrecht zur zu beschichtenden Oberfläche durch die Schicht der Figur 4.

Die erfindungsgemäße Vorrichtung zum Beschichten von Werkstücken mittels Bogenentladung im Vakuum weist eine Vakuumkammer 1 auf, die mit einem Vakuumanschluß 2, einem diesen folgenden Ventil 3 sowie einer Vakuumpumpe 4 versehen ist. Die Vakuumkammer 1 ist zylindrisch ausgebildet und weist eine Zylinderwandung 6 auf. Sie kann auf ihrer Oberseite vakuumdicht durch einen Deckel (nicht dargestellt) verschlossen werden. Die Kammer kann grundsätzlich auch andere Querschnittsformen aufweisen.

In der Zylinderwandung 6 der Vakuumkammer 1 sind zentralsymmetrische Elektroden mit einer inneren Kathode 7 und einer diese umgebenden Anode 8 angeordnet, die mit einer Stromquelle in Verbindung stehen. Es sind mehrere Reihen von Elektroden, vorzugsweise drei oder mehr vertikale Reihen von Elektroden vorgesehen. Zwischen den einzelnen Elektrodenreihen sind Strahlungsheizkörper 9 in Form von Rohrheizkörpern angeordnet, die über Anschlüsse 10 an eine Spannungsquelle anschließbar sind.

Die Wandung 6 der Vakuumkammer besteht vorzugsweise aus zwei Einzelwänden 11,12, zwischen denen sich ein Zwischenraum zur Aufnahme von Kühlwasser 13 befindet, das durch eine Umwälzpumpe umgewälzt und gegebenenfalls über einen Wärmetauscher geführt wird. Zwischen der Wand 12 und dem Heizkörper 9 sind weiterhin Reflektoren 14,16,17, vorzugsweise aus Edelstahl, der poliert ist, angeordnet. Die Reflektoren dienen dazu, die Strahlungswärme des Heizkörpers 9 zum Inneren des Gefäßes zu reflektieren und die Wärme zur Wandung 6 des Gefäßes abzubauen. Die Reflektoren 14,16,17 sitzen auf einem an dem Reflektor 14 befestigten Stift 18 und werden durch zwischen ihnen angeordnete Abstandshalter 19 auf Abstand zueinander gehalten.

Das zu beschichtende Werkstück, wie ein Gußteil, ein Werkzeug, ein Uhrgehäuse oder ein Schmuckstück wird in die Kammer 1 eingegeben und dort durch einen Werkstückhalter (nicht gezeigt) gehalten, der vorzugsweise in der Symmetrieachse der zylindrischen Vakuumkammer 1 angeordnet und um diese drehbar ist. Der Werkstückhalter kann insbesondere auch als Planetenhalter mit einem Planetengetriebe ausgebildet sein, so daß also um eine zentrale Drehachse weitere Drehachsen angeordnet sind, an denen die Werkstücke gehalten werden und die sich zusätzlich zur Drehung um die zentrale Achse um sich selbst drehen. Dies ist an sich im einzelnen bekannt und daher nicht weiter dargestellt.

Als Kathode kommt insbesondere eine Titan-Kathode zur Titan- bzw. Ti-N-Beschichtung in Frage.

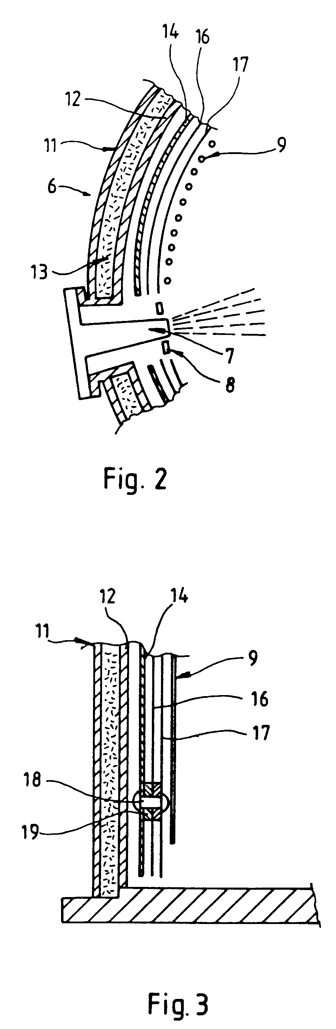

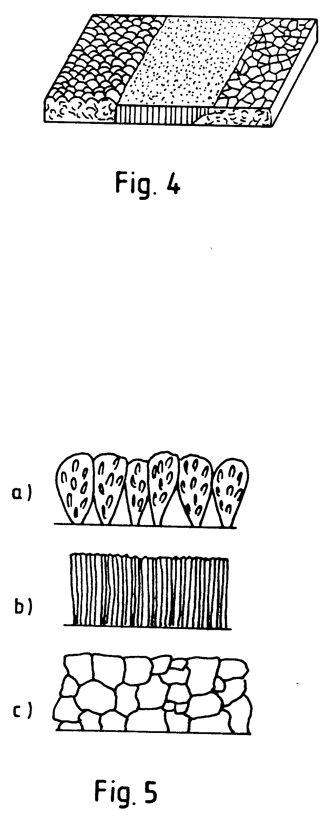

Zunächst wird das zu beschichtende Werkstück oder werden die zu beschichtenden Werkstücke in die Vakuumkammer 1 eingebracht und beispielsweise an den Werkstückhalter angehängt. Anschließend wird die Vakuumkammer vakuumdicht verschlossen und in der Kammer 1 ein Vakuum über die Vakuumpumpe 4 erzeugt. Weiterhin werden die Heizkörper 9 aufgeheizt, bis sie Wärme abstrahlen, wodurch die Werkstücke auf die gewünschte Temperatur im Bereich von 0,3 bis 0,5 des Schmelzpunkts des Beschichtungsmaterials, hier Titan, aufgeheizt sind, beispielsweise bei einer Titanbeschichtung bis auf ca. 800 °K (entsprechend ca. 530 °C). Die Temperatur wird während des nachfolgenden Beschichtungsprozesses konstant gehalten, wofür ein Thermostat vorgesehen sein kann. Anschließend wird die Beschichtung vorgenommen, indem an die Elektroden 7,8 Spannung angelegt wird, vorzugsweise eine Gleichspannung im Bereich von 20 bis 40 Volt. Es entsteht eine Gasentladung mit einem Bogenentladungsstrom von 50 bis 80 A. Hierdurch werden aus der Kathode Ti-Ionen und -tröpfchen verdampft, die aufgrund des Vakuums eine relativ große freie Weglänge haben und sich daher auf dem Werkstück absetzen können. Durch das erfindungsgemäße Verfahren der Vorheizung auf eine Temperatur im Bereich von 0,3 bis 0,5 des Schmelzpunktes des Beschichtungsmaterials wird eine dichte säulenartige Kristallstruktur des Beschichtungsmaterials mit einer weitgehend glatten Oberfläche mit lediglich äußerst geringer Förmigkeit und hoher Materialdichte von über 90 % erreicht (Zone 2 in Figur 4; Figur 5b). Demgegenüber wird bei dem Stand der Technik, der zumindestens zunächst eine Beschichtung bei geringer Temperatur in Kauf nimmt, ein grobkörniger Film mit geringer Dichte erreicht (Zone 1 der Figur 4; Figur 5a). Wenn keine Temperaturregelung vorgenommen wird, so daß die Beschichtung bei übermäßiger Temperatur erfolgt, kann ein fließender Übergang zu der Zone 3 der Figur 3 bzw. Bild 5c erfolgen, wobei die Säulenstruktur verschwindet und eine massive Struktur entsteht. Die Kristallebene auf der Oberfläche nimmt eine entsprechend bestimmte Form an. Insgesamt wird daher durch das erfindungsgemäße Vorgehen eine wesentlich bessere, insbesondere glattere und dichtere Beschichtungsschicht und -oberfläche erreicht.

## Patentansprüche

1. Vorrichtung zum Beschichten von Werkstücken mittels Bogenentladung, wodurch Kathodenmaterial zum Beschichten des Werkstücks verdampft wird, mit einer Vakuumkammer und mindestens einem in dieser angeordneten Elektrodenpaar, gekennzeichnet durch eine in der Vakuumkammer (1) befindliche zusätzliche Heizeinrichtung (9) zum Aufheizen der Werkstücke.

2. Vorrichtung nach Anspruch 1, dadurch gekennzeichnet, daß die Heizeinrichtung (9) ein Heizstrahler ist.

3. Vorrichtung nach Anspruch 1 oder 2, dadurch gekennzeichnet, daß die Heizeinrichtung (9) einen Rohrheizkörper aufweist.

4. Vorrichtung nach einem der Ansprüche 1 bis 3, dadurch gekennzeichnet, daß zwischen Heizeinrichtung (9) und Wandung (12) der Vakuumkammer (1) Mittel zum Temperaturabbau von der Heizeinrichtung (9) zur Wandung (12) angeordnet sind.

5. Vorrichtung nach Anspruch 4, dadurch gekennzeichnet, daß die Mittel zum Temperaturabbau Reflektorplatten (14,16,17) sind.

6. Vorrichtung nach Anspruch 5, dadurch gekennzeichnet, daß die Reflektorplatten aus poliertem Edelstahl bestehen.

7. Vorrichtung nach Anspruch 5 oder 6, dadurch gekennzeichnet, daß mehrere Reflektorplatten hintereinander mittels Abstandshaltern (18,19) auf Abstand gehalten sind.

8. Vorrichtung nach einem der vorangehenden Ansprüche, dadurch gekennzeichnet, daß in der Vakuumkammer (1) ein mit der Versorgung der Heizeinrichtung (9) verbundener Thermostat vorgesehen ist.

9. Verfahren zum Beschichten von Werkstücken mittels Bogenentladung, wobei zunächst ein Unterdruck geschaffen wird und danach bei aufrechterhaltenem Unterdruck aus mindestens einer Kathode mittels Gasentladung Kathodenmaterial, Ionen und Tröpfchen, erzeugt werden, die sich auf dem Werkstück absetzen, dadurch gekennzeichnet, daß vor Einsetzen der Bogenentladung das Werkstück in der Vakuumkammer der Beschichtungsvorrichtung durch eine zusätzliche Heizeinrichtung auf eine Temperatur im Bereich von 0,3 und 0,5 der absoluten Schmelztemperatur des Kathodenmaterials voraufgeheizt wird.

10. Verfahren nach Anspruch 9, dadurch gekennzeichnet, daß bei Titan als Kathodenmaterial das anfängliche Aufheizen bis auf 400-550 °C erfolgt.

## Claims

1. Apparatus for coating workpieces by means of arc discharge, so that cathode material is vaporized for coating the workpiece, having a vacuum chamber and at least one electrode pair located therein, characterized by an additional heating device (9) for heating the workpieces located in the vacuum chamber (1).

2. Apparatus according to claim 1, characterized in that the heating device (9) is a heat radiator.

3. Apparatus according to claim 1 or 2, characterized in that the heating device (9) has a tubular heater.

4. Apparatus according to one of the claims 1 to 3, characterized in that between the heating device (9) and the wall (12) of the vacuum chamber (1) are provided means for reducing the temperature from the heating device (9) to the wall (12).

5. Apparatus according to claim 4, characterized in that the temperature reducing means are reflector plates (14, 16, 17).

6. Apparatus according to claim 5, characterized in that the reflector plates are made from polished high-grade steel.

7. Apparatus according to claim 5 or 6, characterized in that the spacing of several successive reflector plates is maintained by means of spacers (18, 19).

8. Apparatus according to one of the preceding claims, characterized in that the vacuum chamber (1) contains a thermostat connected to the power supply of the heating device (9).

9. Method for coating workpieces by means of arc discharge, in which initially a vacuum is created and subsequently, whilst maintaining the vacuum, cathode material, ions and droplets are produced from at least one cathode by means of a gas discharge and are deposited on the workpiece, characterized in that, prior to the arc discharge, the workpiece is preheated in the vacuum chamber of the coating apparatus by an additional heating device to a temperature in the range of 0.3 and 0.5 of the absolute melting point of the cathode material.

10. Method according to claim 9, characterized in that in the case of titanium as the cathode material initial heating takes place up to 400 to 550°C.

## Revendications

1. Dispositif pour le revêtement de pièces mécaniques au moyen d'une décharge d'arc, par laquelle de la matière d'une cathode est vaporisée pour réaliser le revêtement de la pièce, comprenant une chambre à vide contenant au moins une paire d'électrodes, caractérisé en ce que la chambre à vide (1) comporte une installation de chauffage (9) supplémentaire pour le chauffage de la pièce mécanique.

2. Dispositif selon la revendication 1, caractérisé en ce que l'installation de chauffage (9) est un radiateur.

3. Dispositif selon l'une quelconque des revendications 1 ou 2, caractérisé en ce que l'installation de chauffage (9) est un corps de chauffe tubulaire.

4. Dispositif selon l'une quelconque des revendications 1 à 3, caractérisé en ce qu'entre l'installation de chauffage (9) et la paroi (12) de la chambre à vide (1) sont placés des moyens pour réduire la température de l'installation de chauffage (9) vers la paroi (12).

5. Dispositif selon la revendication 4, caractérisé en ce que les moyens de réduction de la température sont des plaques réflectrices (14,16,17).

6. Dispositif selon la revendication 5, caractérisé en ce que les plaques réflectrices sont en acier inoxydable poli.

7. Dispositif selon l'une quelconque des revendications 5 ou 6, caractérisé en ce que plusieurs plaques réflectrices sont maintenues écartées l'une derrière l'autre au moyen d'entretoises (18,19).

8. Dispositif selon l'une quelconque des revendications précédentes, caractérisé en ce qu'est prévu dans la chambre à vide (1) un thermostat relié à l'alimentation de l'installation de chauffage (9).

9. Procédé pour le revêtement de pièces mécaniques au moyen d'une décharge d'arc, au cours duquel est d'abord créée une dépression, puis sont générés, tout en maintenant cette dépression, au moyen d'une décharge gazeuse à partir d'au moins une cathode, de la matière cathodique, des ions et des gouttelettes se déposant sur la pièce, caractérisé en ce qu'avant application de la décharge d'arc, la pièce est préchauffée dans la chambre à vide du dispositif de revêtement par une installation de chauffage supplémentaire à une température située dans la zone s'étendant entre 0,3 et 0,5 de la température absolue de fusion de la matière cathodique.

10. Procédé selon la revendication 9, caractérisé en ce qu'en cas d'utilisation de titane comme matière cathodique, le préchauffage initial s'effectue jusqu'à 400-550°C.
